Europäisches Patentamt

European Patent Office

Office européen des brevets

(19)

(11) **EP 0 527 693 B1**

(12) **FASCICULE DE BREVET EUROPEEN**

(45) Date de publication et mention
de la délivrance du brevet:
**27.03.1996 Bulletin 1996/13**

(51) Int Cl.⁶: **H03H 17/00, H04N 7/24**

(21) Numéro de dépôt: **92420271.6**

(22) Date de dépôt: **05.08.1992**

(54) **Filtre bidimensionnel à réponse impulsionnelle finie**

Zweidimensionaler nichtrekursiver Filter

Two-dimensional finite impulse response filter

(84) Etats contractants désignés:
**DE FR GB IT**

(30) Priorité: **09.08.1991 FR 9110425**

(43) Date de publication de la demande:
**17.02.1993 Bulletin 1993/07**

(73) Titulaire: **SGS-THOMSON
MICROELECTRONICS S.A.
F-94250 Gentilly (FR)**

(72) Inventeur: **Harrand, Michel
F-38120 Saint Egrève (FR)**

(74) Mandataire: **de Beaumont, Michel
1bis, rue Champollion
F-38000 Grenoble (FR)**

(56) Documents cités:
- **IEEE TRANSACTIONS ON CIRCUITS AND
  SYSTEMS. vol. 36, no. 6, Juin 1989, NEW YORK
  US pages 813 - 820 PARHI ET AL 'Concurrent
  Architectures for Two-Dimensional Recursive
  Digital Filtering'**
- **PATENT ABSTRACTS OF JAPAN vol. 10, no.
  236 (E-435)9 Septembre 1986**

## Description

La présente invention concerne les filtres bidimensionnels à réponse impulsionnelle finie tels qu'utilisés notamment pour le codage d'images de télévision, par exemple pour réaliser un codage dit par "sous-bandes". On décrira ici l'application de l'invention au traitement d'une image de télévision dans laquelle une mémoire contient les pixels successifs d'une image. Il est toutefois clair que l'invention s'applique de façon générale au filtrage de données rangées selon une matrice bidimensionnelle.

Le document JP-A-61,088,668 [NEC] decrit un filtre numérique bidimensionnel comprenant séquentiellement un filtre vertical et un filtre horizontal.

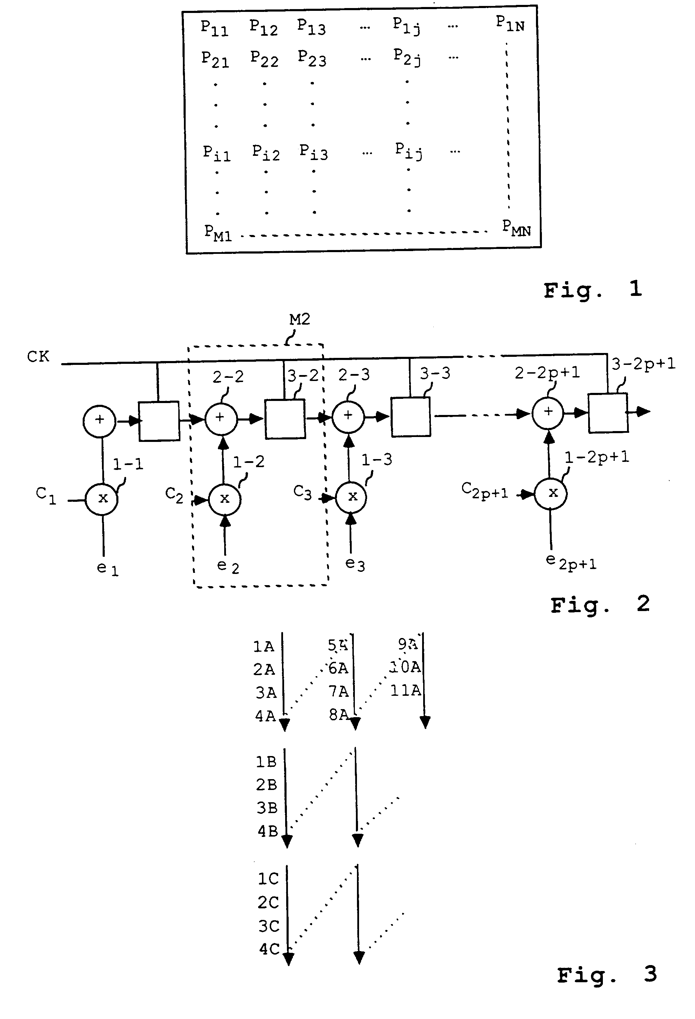

Etant donné une image constituée de pixels $P_{ij}$, tels que représentée en figure 1, où i est un indice de ligne compris entre 1 et M et j est un indice de colonne compris entre 1 et N, un filtrage bidimensionnel de type à réponse impulsionnelle finie ou FIR (Finite Impulse Response) consiste à faire des opérations de combinaison linéaire sur des séquences de pixels d'une ligne et sur des séquences de pixels d'une colonne. On dira que le filtrage est d'ordre 2p+1 si la séquence considérée est une séquence associant 2p+1 pixels successifs.

Ainsi, un filtrage vertical se définit par la relation (1) ci-dessous :

$$Q_{ij} = \sum_{k=i-p}^{k=i+p} C_k * P_{kj} \qquad (1)$$

et un filtrage horizontal se définit par la relation (2) ci-dessous :

$$R_{ij} = \sum_{k=j-p}^{k=j+p} D_k * Q_{ik} \qquad (2)$$

Ces opérations étant linéaires, on notera qu'il est indifférent d'inverser l'ordre des filtrages horizontal et vertical.

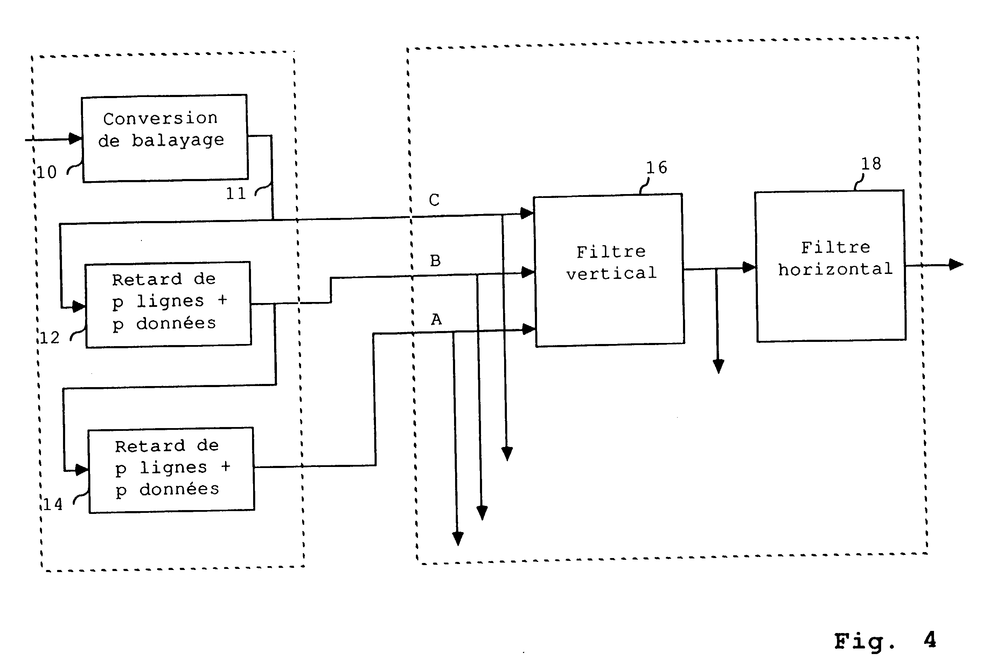

La figure 2 représente un schéma classique de filtre à réponse impulsionnelle finie, servant de base à la construction d'un filtre horizontal ou vertical. Ce filtre est constitué d'une succession de modules identiques $M_1$ à $M_{2p+1}$. Dans la figure, seul le module $M_2$ a été identifié par un encadrement en pointillés. Ce module comprend une borne d'entrée de données $e_2$ vers un multiplieur 1-2 où la donnée d'entrée est multipliée par un coefficient $C_2$. Dans la figure, on a présenté la donnée arrivant sur une ligne unique. En fait, cette donnée sera généralement un mot binaire de plusieurs bits et l'entrée $e_2$ correspond à un bus comprenant autant de lignes que le mot comprend de bits. La sortie du multiplieur 1-2 est envoyée à la première entrée d'un additionneur 2-2 dont la deuxième entrée reçoit la sortie du module précédent. La sortie de l'additionneur est reliée à l'entrée d'un registre à échantillonage sur un front d'horloge 3-2 dont la sortie est connectée à la deuxième entrée de l'additionneur du module suivant. Ces registres sont tous commandés par une horloge CK qui permet, au rythme de l'introduction des données, de lire la donnée présente à la sortie de l'additionneur précédent et d'envoyer la donnée précédemment mémorisée vers l'additionneur suivant.

Il apparaîtra clairement qu'un tel filtre dont toutes les entrées sont interconnectées permet de réaliser l'opération indiquée par la formule (1). En effet, si l'on considère le cas où p=2 (5 modules), et que l'on introduit successivement des données $p_1...p_n$, on obtient sur la sortie S, au sixième temps d'horloge :

$$Q_{13} = C_1 P_{11} + C_2 P_{12} + C_3 P_{13} + C_4 P_{14} + C_5 P_{15},$$

au septième temps d'horloge :

$$Q_{14} = C_1 P_{12} + C_2 P_{13} + C_3 P_{14} + C_4 P_{15} + C_5 P_{16},$$

et ainsi de suite.

Divers correctifs pourront être apportés par l'homme de l'art pour fournir, si nécessaire, les données $Q_{11}$, $Q_{12}$ qui sont incomplètes avec le circuit élémentaire décrit ci-dessus. Ainsi, dans le cas classique où la matrice de données, à savoir une image de pixels de télévision est balayée par lignes horizontales, les données des rangées arrivent séquentiellement et le filtre se prête très simplement à la réalisation d'un filtrage horizontal.

Par contre, pour un filtrage vertical, il faut fournir séquentiellement au filtre les pixels $P_{11}$, $P_{21}$, $P_{31}$... $P_{M1}$ avant de passer aux pixels $P_{12}$, $P_{22}$...$P_{M2}$. Ceci impose, toujours dans le cas du balayage horizontal classique, de prévoir en amont du filtre des lignes à retard ayant sensiblement la durée d'une ligne. Pour un filtre d'ordre 2p+1, il faudra prévoir 2p lignes à retard. Une telle architecture est par exemple décrite dans l'Article de Rao et al. publié dans Proceedings of IEEE International Symposium on Circuits and Systems, New Orleans, Louisiane, mai 1990, pages 3050-3052. Les lignes à retard sont classiquement réalisées au moyen de mémoires et, par exemple pour un filtre d'ordre 17 et des pixels définis sur 8 bits, il faudra prévoir 16 mémoires reliées au filtre par 16 bus de 8 bits. Si le filtre et les lignes à retard sont réalisés dans des puces différentes, ceci oblige pour la puce de filtre à prévoir un nombre de plots de liaison extrêmement important d'où il résulte un coût de boîtier élevé et des performances limitées. En conséquence, on a proposé d'inclure les mémoires servant de lignes à retard dans la puce du filtre. Mais alors, elle représente une surface de silicium très importante. En outre, les technologies de fabrication de mémoire optimisées ne sont généralement pas les mêmes que celles utilisées pour la fabrication des cellules d'un filtre. Il en résulte que la puce d'ensemble n'est pas optimisée. De toute façon, cette intégration sur une seule puce des filtres et des mémoires devient impossible quand l'ordre du filtre devient trop élevé, par exemple 65, ou quand les mots de données à traiter comprennent un trop grand nombre de bits, par exemple 16 ou 32.

Ce problème est d'autant plus aigu que, dans certains circuits de télévision, par exemple ceux prévus en télévision haute définition, dans lesquels on veut réaliser une technique de codage sous-bandes, on prévoit plusieurs filtres par téléviseur.

Ainsi, un objet de la présente invention est de prévoir une nouvelle architecture de filtre bidimensionnel à réponse impulsionnelle finie (FIR) permettant d'optimiser la réalisation du filtre vertical sans reporter la difficulté sur le filtre horizontal associé.

Un autre objet de la présente invention est de prévoir un filtre bidimensionnel FIR dans lequel la partie mémoire et la partie filtre proprement dite puissent être réalisées dans des puces séparées avec un nombre de liaisons limité entre les deux puces.

Pour atteindre ces objets ainsi que d'autres, la présente invention prévoit de façon générale un filtre numérique bidimensionnel d'ordre $2p+1$, avec $p>1$, pour le traitement de données matricielles, comprenant séquentiellement un filtre "vertical" et un filtre "horizontal". Les données matricielles sont appliquées au filtre vertical par un moyen de balayage vertical de bandes horizontales d'une hauteur de $p$ données de la matrice de données et le filtre horizontal reçoit les données de sortie du filtre vertical selon le même type de balayage.

Plus particulièrement, la présente invention prévoit un filtre bidimensionnel à réponse impulsionnelle finie d'ordre $2p+1$ pour le traitement de données associant un filtre "vertical" et un filtre "horizontal", chaque filtre comportant $2p+1$ cellules dont chacune comprend une entrée de données reliée à un multiplieur par un coefficient déterminé, la sortie du multiplieur étant reliée à la première entrée d'un additionneur, dont la sortie est reliée à un registre, la sortie du registre étant connectée à la deuxième entrée de l'additionneur de la cellule suivante, les registres étant commandés au rythme de l'introduction des données. Le filtre vertical comprend des moyens pour balayer verticalement les données par bandes d'une hauteur de $p$ données ; des moyens pour fournir simultanément sur une première ligne une donnée d'une bande, sur une deuxième ligne une donnée de la bande précédente décalée de $p$ données, sur une troisième ligne une donnée de la bande encore précédente décalée encore de $p$ données ; et des moyens pour, à chaque temps d'horloge, connecter chaque entrée de cellule à l'une des trois lignes.

Selon un mode de réalisation de la présente invention, le filtre horizontal comprend des moyens pour fournir simultanément à ses entrées les données de sortie du filtre vertical mutuellement décalées de $p+1$ données.

Selon un mode de réalisation de la présente invention, les entrées sur les lignes 1, $p+1$ et $2p+1$ du filtre vertical sont directes et les autres entrées sont équipées de multiplexeurs à deux voies commandés de sorte que la séquence de connexion des entrées aux lignes est la suivante :

- entrée 1 : toujours connectée à la première ligne ;
- entrée $l$ ($1<l<p+1$) : $l-1$ fois à la deuxième ligne puis $p-l+1$ fois à la première ligne ;
- entrée $p+1$ toujours connectée à la deuxième ligne ;
- entrée $m$ ($p<m<2p+1$) : $m-p-1$ fois à la troisième ligne puis $2p+1-m$ fois à la deuxième ligne ;
- entrée $2p+1$ : toujours connectée à la troisième ligne ;

un séquenceur signalant la première donnée d'une colonne par laquelle débute cette séquence.

Ces objets, caractéristiques et avantages ainsi que d'autres de la présente invention seront exposés en détail dans la description suivante de modes de réalisation particuliers faite en relation avec les figures jointes parmi lesquelles :

la figure 1, précédemment décrite, représente une mémoire d'image ;
la figure 2, précédemment décrite, représente une cellule classique de filtre à réponse impulsionnelle finie ;
la figure 3 illustre un mode de balayage utilisé selon la présente invention ;
la figure 4 représente l'architecture d'ensemble d'un filtre selon la présente invention ;
la figure 5 représente la partie de filtre proprement dite d'un filtre vertical selon la présente invention ; et
la figure 6 représente la partie de filtre proprement dite d'un filtre horizontal selon la présente invention.

Pour faciliter et simplifier la réalisation pratique d'un filtre bidimensionnel à réponse impulsionnelle finie, la présente invention propose d'utiliser un balayage vertical par bandes plutôt qu'un balayage horizontal par trames classique.

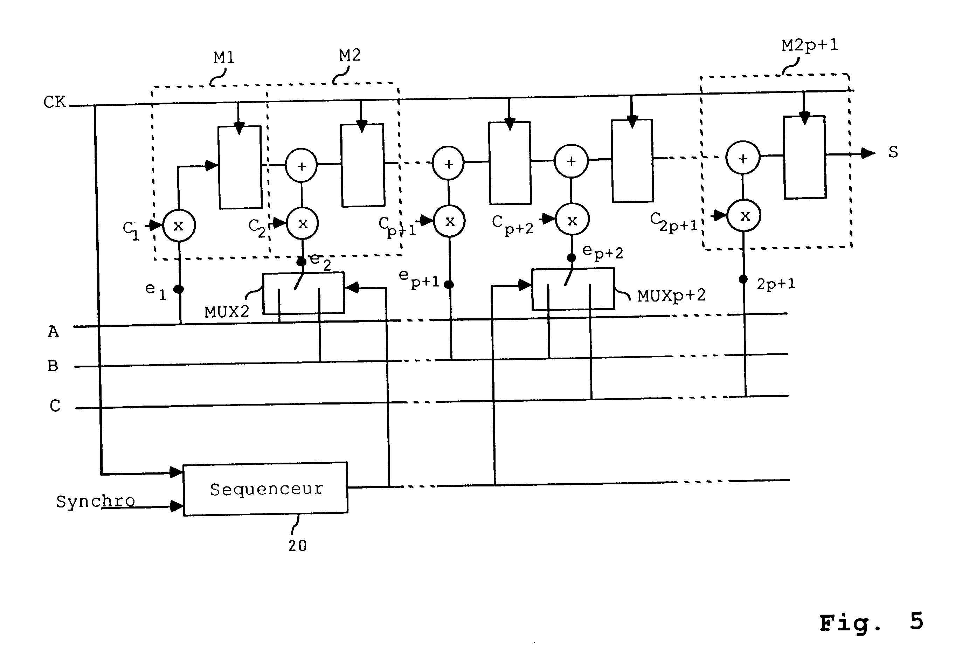

La figure 3 est destinée à illustrer le mode de balayage utilisé et les notations qui seront utilisées dans la suite du présent texte.

Dans ce qui suit, pour simplifier l'exposé, on considèrera le cas particulier d'un filtre récursif d'ordre 9, c'est-à-dire p=4 et 2p+1 =9. Dans ce cas, la présente invention propose de réaliser un balayage vertical par bandes d'une hauteur de p=4 pixels. La figure 3 illustre trois bandes de balayage successives, les éléments de la première bande étant désignés verticalement par 1A, 2A, 3A, 4A ; 5A, 6A, 7A, 8A ; 9A, 10A, 11A, 12A ; 13A..., les éléments correspondants des deux bandes suivantes étant désignés par le même chiffre et respectivement les lettres B et C.

La figure 4 représente l'architecture générale d'un système de filtrage bidimensionnel, vertical et horizontal, selon la présente invention.

Ce système comprend un circuit de conversion de balayage 10 fournissant un balayage vertical par bandes du type illustré en figure 3 sur une sortie 11. Ce circuit est suivi de deux mémoires de retard de p lignes + p données (ici p=4). On désigne par C, B et A la sortie du circuit de conversion de balayage 10, de la première mémoire de retard 12 et de la deuxième mémoire de retard 14, respectivement. Ces sorties C, B, A sont envoyées sur un filtre vertical 16 et éventuellement vers d'autres filtres verticaux analogues non représentés. La sortie du filtre vertical est envoyée à un filtre horizontal 18 et éventuellement à d'autres filtres horizontaux non représentés.

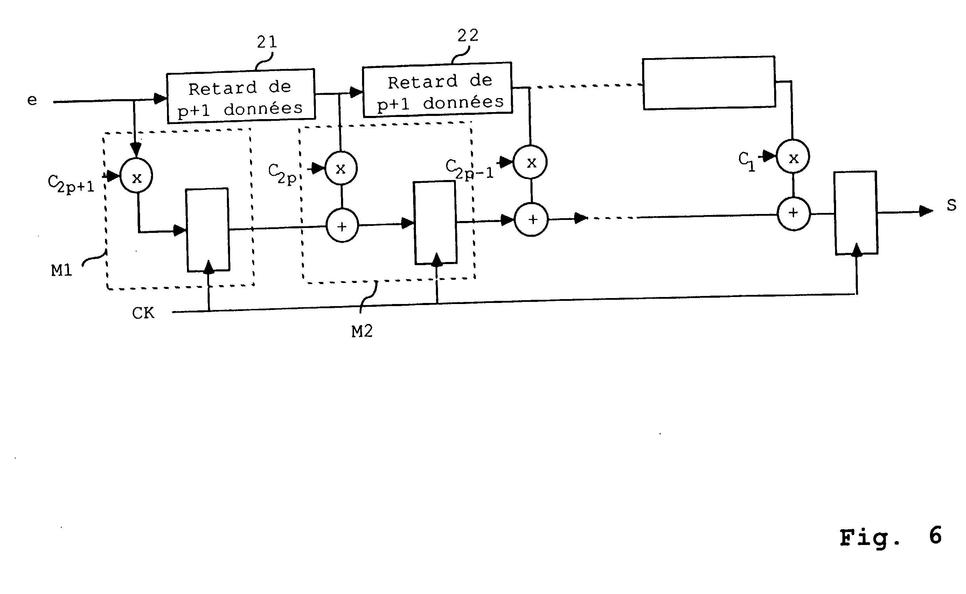

La figure 5 représente un mode de réalisation du filtre vertical 16 et précise ses connexions avec les bus A, B et C. Le filtre 16 est du type illustré en figure 2.

Pour des raisons qui apparaîtront ci -après, l'entrée $e_1$ de la cellule $M_1$ est reliée au bus A, l'entrée $e_{p+1}$ de la cellule $M_{p+1}$ est reliée au bus B, et l'entrée $e_{2p+1}$ de la cellule $M_{2p+1}$ est reliée au bus C. Les cellules comprises entre la cellule $M_1$ et la cellule $M_{p+1}$ ont leur entrée qui peut être reliée par un multiplexeur MUX à l'un ou l'autre des bus A et B, et les cellules comprises entre la cellule $M_{p+1}$ et la cellule $M_{2p+1}$ ont leur entrée qui peut être reliée par un multiplexeur à l'un ou l'autre des bus B et C.

En se référant aux notations de la figure 3, il apparaît clairement que l'on veut fournir séquentiellement aux entrées e1 à e9, dans le cas où p=4, les signaux suivants :

| | e1 | e2 | e3 | e4 | e5 | e6 | e7 | e8 | e9 | S |
|---|---|---|---|---|---|---|---|---|---|---|
| | 1A | | | | | | | | | |
| | 2A | 2A | | | | | | | | |
| | 3A | 3A | 3A | | | | | | | |
| | 4A | 4A | 4A | 4A | | | | | | |
| | 5A | 1B | 1B | 1B | 1B | | | | | |
| | 6A | 6A | 2B | 2B | 2B | 2B | | | | |
| | 7A | 7A | 7A | 3B | 3B | 3B | 3B | | | |
| | 8A | 8A | 8A | 8A | 4B | 4B | 4B | 4B | | |
| | 9A | 5B | 5B | 5B | 5B | 1C | 1C | 1C | 1C | |
| | 10A | 10A | 6B | 6B | 6B | 6B | 2C | 2C | 2C | → 1S |
| | 11A | 11A | 11A | 7B | 7B | 7B | 7B | 3C | 3C | → 2S |
| | 12A | 12A | 12A | 12A | 8B | 8B | 8B | 8B | 4C | → 3S |
| | 13A | 9B | 9B | 9B | 9B | 5C | 5C | 5C | 5C | → 4S |
| | 14A | 10B | 10B | 10B | 10B | 6C | 6C | 6C | 6C | → 5S |

temps

On déduit de ce tableau la règle générale à suivre. Le bus B doit présenter les données du bus A décalées de p (=4) lignes plus p (=4) périodes d'horloge et de même le bus C doit présenter celles du bus B retardées de p lignes plus p périodes d'horloge afin, par exemple, de présenter simultanément au filtre les pixels 9A, 5B et 1C ; 10A, 6B et 2C ; 11A, 7B et 3C... Ce résultat est obtenu avec les circuits de retard réglés de la façon indiquée en figure 4. Par ailleurs, on voit que les séquences de commande des multiplexeurs de chacune des entrées sont :

4

```
  A   B   B   B   B   C   C   C   C
  A   A   B   B   B   B   C   C   C
  A   A   A   B   B   B   B   C   C
  A   A   A   A   B   B   B   B   C
```

temps

Cette séquence est périodique de période 4 (p) et commence en même temps qu'est présenté un pixel de la ligne supérieure (1A par exemple). Un séquenceur 20 déclenché par un signal de synchronisation permet d'assurer cette fonction. On voit à partir du tableau précédent que les entrées 1, 5 et 9 (1, p+1 et 2p+1) n'ont pas besoin d'être associées à un multiplexeur.

Plus généralement, pour un filtre d'ordre 2p+1, chacun des trois bus A, B, C balaye p lignes vidéo et la séquence de commande du multiplexeur, périodique de période p, est la suivante :

| Entrée e1 : | toujours connectée à A |
|---|---|
| Entrée e2 : | 1 fois B, puis (p-1) fois A |
| Entrée el (1<l<p+1) : | l-1 fois B, puis (p-l+1) fois A |
| Entrée ep+1 : | toujours connectée à B |
| Entrée em (p+1<m<2p+1) : | m-p-1 fois C, puis 2p+1-m fois B |
| Entrée e2p+1 : | toujours connectée à C |

En revenant sur la figure 4, on constate que le circuit selon la présente invention permet de relier des ensembles de circuits de mémoire et de conversion de balayage à un circuit de filtre proprement dit par seulement trois bus au lieu de 2p dans l'art antérieur. Ceci est très significatif quand le filtre est d'ordre élevé (p=8, 16, ou 32) et que les données à filtrer comprennent un grand nombre de bits (8, 16 ou 32). Ainsi, on pourra fabriquer les circuits de filtre avec des technologies de type processeur particulièrement bien adaptées à cette fabrication et fabriquer le circuit comprenant les mémoires avec également des circuits adaptés, par exemple des circuits de mémoire DRAM, qui permettent d'intégrer un très grand nombre de cellules sur une surface relativement réduite.

On notera que, par rapport au circuit de l'art antérieur, la partie mémoire proprement dite selon la présente invention, comprend deux mémoires de p lignes plus une mémoire également de p lignes pour la conversion de balayage. Alors que, dans l'art antérieur, seulement 2p mémoires d'une ligne étaient utilisées. Cet inconvénient de l'invention n'est qu'apparent, d'une part, en raison de l'avantage très important de réduction du nombre de bus reliant les mémoires au filtre et donc du nombre de plots du circuit de filtre, d'autre part, parce que selon l'invention, les mémoires peuvent être réalisées sur une puce séparée de technologie adaptée. En outre, on notera que le circuit de conversion de balayage est souvent utilisé également dans d'autres parties d'un système de traitement d'images de télévision.

Par ailleurs, on va montrer en relation avec la figure 6 que la simplification importante apportée par la présente invention à la réalisation du filtre vertical n'entraîne pas une complexification notable du filtre horizontal.

A la sortie du filtre vertical, les données sont balayées par bandes. Le filtre horizontal doit donc recevoir sur ses entrées successives des données espacées les unes des autres de p+1 coups d'horloge. Ceci est facilement réalisé avec le circuit illustré en figure 6, où de mêmes références désignent de mêmes éléments que dans les figures précédentes et où l'on notera qu'entre chacune des entrées est prévue une mémoire 21, 22... de retard de p+1 données, c'est-à-dire une mémoire de petite capacité devant les mémoires d'une durée d'une ligne (rappelons que couramment en télévision classique, une ligne comprend environ 700 pixels et en télévision haute définition, environ 2 000 pixels).

Dans des applications de codage par sous-bandes, on prévoira de façon classique une élimination d'un nombre choisi de données d'une séquence à la sortie de chaque filtre et une cadence de balayage appropriée.

**Revendications**

1. Filtre numérique bidimensionnel d'ordre 2p+1, avec p>l, pour le traitement de données matricielles, comprenant séquentiellement un filtre "vertical" (16) et un filtre "horizontal" (18), caractérisé en ce que lesdites données matricielles sont appliquées au filtre vertical par un moyen (10) de balayage vertical de bandes horizontales d'une hauteur de p données de la matrice de données et en ce que le filtre horizontal reçoit les données de sortie du filtre vertical selon le même type de balayage.

**2.** Filtre bidimensionnel selon la revendication 1, à réponse impulsionnelle finie d'ordre 2p+1, avec p>1, pour le traitement de données associant le filtre "vertical" (16) et le filtre "horizontal" (18), chaque filtre comportant 2p+1 cellules (M) dont chacune comprend une entrée de données (e) reliée à un multiplieur (1) par un coefficient déterminé, la sortie du multiplieur étant reliée à la première entrée d'un additionneur (2), dont la sortie est reliée à un registre (3), la sortie du registre étant connectée à la deuxième entrée de l'additionneur de la cellule suivante, les registres étant commandés au rythme de l'introduction des données, le filtre vertical comprenant :

- des moyens (11, 12, 14) pour fournir simultanément :

  . sur une première ligne (C) une donnée d'une bande,
  . sur une deuxième ligne (B) une donnée de la bande précédente décalée de p données,
  . sur une troisième ligne (A) une donnée de la bande encore précédente décalée encore de p données ; et

- des moyens pour, à chaque temps d'horloge, connecter chaque entrée de cellule à l'une desdites trois lignes.

**3.** Filtre bidimensionnel selon la revendication 1, caractérisé en ce que le filtre horizontal (18) comprend des moyens pour fournir simultanément à ses entrées les données de sortie du filtre vertical (16) mutuellement décalées de p+1 données.

**4.** Filtre bidimensionnel selon la revendication 2, caractérisé en ce que les entrées sur les lignes 1, p+1 et 2p+1 sont directes et en ce que les autres entrées sont équipées de multiplexeurs à deux voies (MUX) commandés de sorte que la séquence de connexion des entrées aux lignes est la suivante :

- entrée 1 : toujours connectée à la première ligne ;
- entrée l (1<l <p+1) : l-1 fois à la deuxième ligne puis p-l+1 fois à la première ligne ;
- entrée p+1 toujours connectée à la deuxième ligne ;
- entrée m (p<m<2p+1) : m-p-1 fois à la troisième ligne puis 2p+1-m fois à la deuxième ligne ;
- entrée 2p+1 : toujours connectée à la troisième ligne ;

un séquenceur (10) signalant la première donnée d'une colonne par laquelle débute cette séquence.


**Patentansprüche**

**1.** Zweidimensionaler digitaler Filter von der Ordnung 2p+1 mit p>1 für die Verarbeitung von Matrixdaten, der sequentiell einen "vertikalen" Filter (16) und einen "horizontalen" Filter (18) umfaßt, dadurch **gekennzeichnet**, daß die Matrixdaten dem vertikalen Filter über eine Einrichtung (10) zum vertikalen Abtasten von horizontalen Streifen der Datenmatrix mit einer Höhe von p Daten zugeführt werden und daß der horizontale Filter die Ausgangsdaten des vertikalen Filters entsprechend derselben Art der Abtastung empfängt.

**2.** Zweidimensionaler Filter ohne Signalrückführung von der Ordnung 2p+1 mit p>1 nach Anspruch 1 für die Verarbeitung von Daten unter Einbeziehung des "vertikalen" Filters (16) und des "horizontalen" Filters (18), wobei jeder Filter 2p+1 Zellen (M) umfaßt, von denen jede einen Dateneingang (e) umfaßt, der mit einem Multiplizierer (1) zum Multiplizieren mit einem vorbestimmten Koeffizienten verbunden ist, wobei der Ausgang des Multiplizierers mit dem ersten Eingang eines Addierers (2) verbunden ist, dessen Ausgang mit einem Register (3) verbunden ist, wobei der Ausgang des Registers mit dem zweiten Eingang des Addierers der folgenden Zelle verbunden ist und die Register im Takt der Zuführung der Daten gesteuert werden, wobei der vertikale Filter umfaßt:
eine Einrichtung (11, 12, 14) um gleichzeitig das folgende zu liefern:

- auf einer ersten Leitung (C) ein Datenelement eines Streifens,
- auf einer zweiten Leitung (B), um p-Daten verschoben, ein Datenelement des vorangehenden Streifens,
- auf einer dritten Leitung (A), noch einmal um p Daten verschoben, ein Datenelement des noch weiter vorangehenden Streifens, und

eine Einrichtung zum Verbinden jedes Eingangs einer Zelle mit einer der drei Leitungen zu jeder Taktzeit.

**3.** Zweidimensionaler Filter nach Anspruch 1, dadurch **gekennzeichnet**, daß der horizontale Filter (18) eine Einrichtung dafür umfaßt, daß gleichzeitig an seine Eingänge, gegeneinander um p+1-Daten verschoben, die Ausgangsdaten des vertikalen Filters (16) geliefert werden.

4.  Zweidimensionaler Filter nach Anspruch 2, dadurch **gekennzeichnet**, daß die Eingänge auf den Leitungen 1, p+1 und 2p+1 direkt sind und daß die anderen Eingänge mit Zweiweg-Multiplexern (MUX) ausgerüstet sind, welche derart gesteuert werden, daß die Abfolge der Verbindung der Eingänge mit den Leitungen die folgende ist:

-   Eingang 1: immer mit der ersten Leitung verbunden,
-   Eingang l (l<1<p+1): l-1 mal mit der zweiten Leitung, danach p-l+1 mal mit der ersten Leitung,
-   Eingang p+1: immer mit der zweiten Leitung verbunden,
-   Eingang m (p<m<2p+1): m-p-1 mal mit der dritten Leitung, danach 2p+1-m mal mit der zweiten Leitung,
-   Eingang 2p+1: immer mit der dritten Leitung verbunden,

wobei ein Sequenzer (10) das erste Datenelement einer Spalte angibt, mit der diese Sequenz beginnt.

## Claims

1.  A digital bidimensional filter of rank 2p+1, with p>1, for processing matrix data, sequentially comprising a "vertical" filter (16) and a "horizontal" filter (18), characterized in that said matrix data are applied to the vertical filter by a circuit (10) vertically scanning horizontal stripes of a height of p data in the data matrix, and in that the horizontal filter receives the output data from the vertical filter according to the same scanning mode.

2.  A bidimensional Finite Impulse Response (FIR) filter of rank 2p+1, with p>1, according to claim 1, for data processing associating the "vertical" filter (16) and the "horizontal" filter (18), each filter comprising 2p+1 cells (M), each of which comprises a data input (e) connected to a multiplier (1) by a predetermined coefficient, the output of said multiplier being connected to the first input of an adder (2), the output of which is connected to a register (3), the output of said register being connected to the second input of an adder of the next cell, the registers being controlled at the rate of data introduction, said vertical filter comprising:

    -   means (11, 12, 14) for simultaneously providing:

        .   on a first line (C) a datum of a stripe,
        .   on a second line (B) a datum of the former stripe shifted by p data,
        .   on a third line (A), a datum of the still former stripe again shifted by p data; and

    -   means for, at each clock time, connecting each cell input to one of said three lines.

3.  A bidimensional filter according to claim 1, characterized in that said horizontal filter (18) comprises means for simultaneously providing to its inputs the output data of said vertical filter (16) mutually shifted by p+1 data.

4.  A bidimensional filter according to claim 2, characterized in that the inputs on lines 1, p+1 and 2p+1 are direct, the other inputs being associated with two-way multiplexers (MUX) controlled so that the connection sequence of inputs to the lines is as follows:

    -   input 1 : always connected to the first line;
    -   input l (1<l<p+1): l-1 times to the second line, then p-l+1 times to the first line;
    -   input p+1 : always connected to the second line;
    -   input m(p<m<2p+1): m-p-1 times to the third line, then 2p+1-m times to the second line;
    -   input 2p+1 : always connected to the third line; a sequencer (10) indicating the first datum of a column by which said sequence starts.

$$
\begin{array}{cccccc}
P_{11} & P_{12} & P_{13} & \ldots & P_{1j} & \ldots & P_{1N} \\
P_{21} & P_{22} & P_{23} & \ldots & P_{2j} & \ldots & \\
\cdot & \cdot & \cdot & & \cdot & & \\
\cdot & \cdot & \cdot & & \cdot & & \\
\cdot & \cdot & \cdot & & \cdot & & \\
P_{i1} & P_{i2} & P_{i3} & \ldots & P_{ij} & \ldots & \\
\cdot & \cdot & \cdot & & \cdot & & \\
\cdot & \cdot & \cdot & & \cdot & & \\
\cdot & \cdot & \cdot & & \cdot & & \\
P_{M1} & \text{-----} & & & & & P_{MN}
\end{array}
$$

Fig. 1

Fig. 2

Fig. 3

Fig. 4

EP 0 527 693 B1

Fig. 5

EP 0 527 693 B1

EP 0 527 693 B1

21

22

e

Retard de p+1 données

Retard de p+1 données

$C_{2p+1}$ ×

$C_{2p}$ ×

$C_{2p-1}$ ×

$C_1$ × +

+

+

M1

M2

CK

S

Fig. 6